Europäisches Patentamt

European Patent Office

Office européen des brevets

(11) Publication number: **0 131 817**
**B1**

# EUROPEAN PATENT SPECIFICATION

(45) Date of publication of patent specification: **31.05.89**

(21) Application number: **84107530.2**

(22) Date of filing: **29.06.84**

(51) Int. Cl.⁴: **H 03 M 3/04**

(54) Adaptive differential PCM system with residual-driven adaptation of feedback predictor.

(30) Priority: **18.07.83 CA 432615**
**28.10.83 US 546738**

(43) Date of publication of application:
**23.01.85 Bulletin 85/04**

(45) Publication of the grant of the patent:
**31.05.89 Bulletin 89/22**

(84) Designated Contracting States:
**AT DE FR GB IT NL SE**

(56) References cited:
**PROCEEDINGS OF ICASSP '82, 3rd-5th May
1982, Paris, France, vol. 2, pages 960-963, IEEE,
New York, US; T. NISHITANI et al.: "A 32kb/s
toll quality ADPCM codec using a single chip
signal processor"**
**PROCEEDINGS OF ICC '84, LINKS FOR THE
FUTURE, 14th-17th May 1984, Amsterdam,
Holland, vol. 3, pages 1508-1512, IEEE, New
York, US; D. MILLAR et al.: "Prevention of
predictor mistracking in ADPCM coders"**
**PROCEEDINGS OF ICASSP 82, 3rd-5th May
1982, Paris, France, vol. 2, pages 964-967, IEEE,
New York, US; D. COINTOT: "A 32-kbit/sec
ADPCM coder robust to channel errors"**
(73) Proprietor: **NORTHERN TELECOM LIMITED**
**1600 Dorchester Boulevard West
Montreal Quebec H3H 1R1 (CA)**

(72) Inventor: **Millar, Douglas James
668 De Gaspe Apt. 303
Nun's Island Verdun Quebec (CA)**

(74) Representative: **Crawford, Andrew Birkby et al
A.A. THORNTON & CO. Northumberland House
303-306 High Holborn
London WC1V 7LE (GB)**

Courier Press, Leamington Spa, England.

# EP 0 131 817 B1

**Description**

The invention relates to adaptive differential pulse code modulation systems with residual adaptation of feedback predictor and in particular such systems having adaptive prediction coefficients.

The invention is particularly concerned with adaptive differential pulse code modulation (ADPCM) systems of the kind exemplified as prior art in U.S. Patent No. 4,317,208, issued February 23, 1982 to Takashi Areski, to which the reader is directed for reference. Generally such systems include a transmitter in which a subtractor provides the difference between the instant signal sample and a prediction signal derived from one or more earlier samples. The difference signal is then quantized and transmitted. The receiver includes an inverse quantizer and a predictor which reconstruct the signal from the received difference or residual signal. Usually the quantizers will be adaptive so as to vary the step size, or transfer function slope, according to the magnitude of the input difference signal. This better utilizes the dynamic range of the quantizer and improves response to low amplitude signals.

Additionally, each predictor may be adaptive, i.e. its coefficients change with time, to better follow the variations with time of the signal to be predicted, and to optimize performance with different types of signal, for example voice, voiceband data. In effect the predictor transfer function is adapted to the time varying input signal so that, ideally, the energy in the difference or residual signal is minimized at all times. In ADPCM systems the values of the predictor coefficients are not transmitted explicitly to the receiver, but are derived from the quantized difference siganl in an identical manner in both the transmitter and the receiver.

One type of predictor, known as "pole-based", uses a feedback loop and derives its coefficients according to the equation:—

$$A_i^{j+1} = A_i^j + g \cdot F_1(X'_{j-i}) \cdot F_2(\hat{E}_j) \qquad\qquad 1$$

where g is a small positive value and $F_1$ and $F_2$ are nondecreasing functions. As discussed in U.S. Patent No. 4,317,208, in such systems the coefficients of the receiver differ from those of the transmitter if transmission errors occur. This is because the prediction coefficients in the receiver are derived from the received difference signal. Errors in this signal cause the receiver prediction coefficients to depart from those in the transmitter. The difference or mistracking may persist even when the errors have ceased.

It has been proposed to alleviate this problem by deriving the prediction coefficients $A_i$ according to the equation:—

$$A_i^{j+1} = A_i^j(1-\delta) + g \cdot F_1(X'_{j-i})F_2(\hat{E}_j) \qquad\qquad 2$$

where i=1 to N, $\delta$ is a positive value much smaller than 1, g is a proper positive constant, $\hat{E}_j$ is derived from the quantized difference between the input signal and the prediction signal. and $F_1$ and $F_2$ are non-decreasing functions.

Inclusion of the term $(1-\delta)$ is intended to cause the receiver's predictor coefficient values to gradually converge to those of the transmitter predictor at a rate determined by $\delta$. This desirable property has been termed tracking of the receiver predictor coefficients.

Even so, instability of oscillation of the receiver may still occur because of the feedback loop in the predictor which uses both the difference signal $\hat{E}_j$ and the preceding reconstructed signal $X'_{j-i}$ to derive the predictor coefficients. Usually stability checking is used to ensure that the predictor coefficients remain within prescribed ranges. A drawback of such stability checking is the increased complexity as the number of poles (coefficients) increases.

In U.S. Patent No. 4,317,208, Araseki proposes overcoming the stability problem by using a zero-based predictor, i.e. which does not have a feedback loop. However, whilst such zero-based predictors are not susceptible to instability, they do suffer from the disadvantage that they provide less prediction gain for speech and like signals then pole-based predictors. It is possible to use both a pole-based predictor and a zero-based predictor, as suggested by Araseki, to gain the advantages of each. However, it has been found that, whether combined wiht a zero-based predictor or not, a pole based predictor is still vulnerable to mistracking if the input signal contains two tones of equal amplitude but different frequency. A particular problem arises with the tones used for dual tone multiple frequency (DTMF) signalling in the telephone network, but a problem may also arise with some modems which use tones differing by more than about 300 Hz. With such signals the predictor adaptation driven via the feedback loop by the predictor output signal, may have multiple stable states. Thus, once transmission errors have produced mistracking the receiver may stabilize with its predictor coefficients at values different from those of the transmitter. It transfer function, which is normally the inverse of that of the transmitter, will have a distorted frequency response, so one tone will be attenuated and the other amplified, possibly to an extent that the inequality is unacceptable.

In summary, zero-based predictors overcome the problems of instability and mistracking, but suffer from low predictor gain. Pole-based predictors can be made stable by applying a stability check, but hitherto have suffered from mistracking.

The present invention provides a transmitter for transmitting an adaptive differential pulse code

2

modulated signal, including; a subtractor for deriving the difference $E_j$ between an input signal $X_j$ and a predicted value $\hat{X}_j$, a quantizer for quantizing the difference signal $E_j$ from said subtractor to obtain a numeric representation $N_j$ thereof;

an inverse quantizer for recovering the difference signal $\hat{E}_j$ from said numeric representation $N_j$, summing means for summing the difference signal $\hat{E}_j$ and the predicted value $\hat{X}_j$ to provide a reconstructed signal $X'_j$;

predictor means having variable prediction coefficients for receiving reconstructed signal $X'_j$ from said summing means and generating therefrom an output signal $\hat{X}_{jp}$ constituting at least part of said predicted value $\hat{X}_j$; and

a feedback loop for applying said predicted value $\hat{X}_j$ to said summing means;

characterised in that

said predictor means is adapted to derive each predictor coefficient as a non-linear function dependent upon a finite number of past values of the difference signal or residual ($\hat{E}_j$) and not directly dependent on the reconstructed signal $X_j$.

The present invention further provides a receiver for receiving an adaptive differential pulse code modulated signal, comprising:

an inverse quantizer for recovering a receiver quantized difference signal $\hat{E}_j$ from a received numeric representation, $N_j$;

summing means for combining a predicted value $\hat{X}_j$ and a receiver quantized difference signal $\hat{E}_j$ to provide a reconstructed signal $\tilde{X}_j$;

predictor means having variable prediction coefficients, for receiving said reconstructed signal and providing therefrom a predictor output $\hat{X}_{jp}$ constituting at least part of said predicted value $\hat{X}_j$; characterized in that said predictor means is adapted to derive each predictor coefficient as a non-linear function dependent upon a finite number of past values of the difference signal or residual $\hat{E}_j$ and not directly dependent on the reconstructed signal $\tilde{X}_j$.

Where the predictor has a plurality of coefficients, corresponding to past values occurring at different times, the non-linear function may be derived also from the immediate past coefficient values of one or more lower numbered predictor coefficients. Generally, the higher the number of the coefficient, the earlier the past value to which it corresponds. Thus the first or lowest predictor coefficient will not be a non-linear function of any past coefficient value.

This is in contrast to prior implementations, such as that by Araseki, wherein this function is derived in part from the reconstructed signal $X'_j$, which derives from all of the immediate past coefficient values.

More particularly the predicted values $\hat{X}_j$ may be derived in accordance with the equation:—

$$\hat{X}_j = A_1 X'_{j-1} + A_2 X'_{j-2} \ldots + A_n X'_{j-n} \qquad\qquad 3$$

where $A_1$ to $A_n$ are the individual predictor coefficients $A_i$ derived in accordance with the equation:—

$$A_i^{j+1} = A_i^j(1-\delta_i) + g \cdot F_i(\hat{E}_j, \hat{E}_{j-1}, \ldots \hat{E}_{j-n}, A_1^j \ldots A_{i-1}^j) \qquad\qquad 4$$

where $i = 1 \ldots n$, the number of pole-predictor coefficients.

$\delta_i$ is a positive constant much small than one

$g$ is a proper positive constant

$\hat{E}_j$ is the value of the (quantized) difference signal at time point j and

$A'_i$ is the respective predictor coefficient at time point j, and

$F_i$ is a non-linear function.

It should be noted that for the case $i=1$, i.e. the first or only pole, there are no A arguments.

In a preferred embodiment having a two pole predictor the two predictor coefficients $A_1$ and $A_2$ are derived in accordance with the equations:—

$$A_1^{j+1} = A_1^j(1-\delta_1) + g_1 \cdot \hat{E}_j \cdot \hat{E}_{j-1}/K_j \qquad\qquad 5$$

$$A_2^{j+1} = A_2^j(1-\delta_2) + g_2 \cdot [\hat{E}_j \cdot \hat{E}_{j-2} - A_1^j \cdot \hat{E}_j \cdot \hat{E}_{j-1}]/K_j \qquad\qquad 6$$

where

j is a particular sample period,

$\delta_1$ and $\delta_2$ are positive values much smaller than 1 (e.g. 1/256 and 1/128, respectively);

d is a small positive constant;

$g_1$ and $g_2$ are proper positive constants, for example each 1/32; and

$K = \text{Max}(d, \hat{E}_j, \hat{E}_{j-1}, \hat{E}_{j-2})$

The aforementioned embodiments of the invention, (with a pole-based predictor) may be used alone or with an additional predictor not employing feedback (zero-based). When such an additional predictor is provided, it may also be preferable to derive the prediction coefficients for the pole-based predictor not only from the difference signal, but also from the output of the zero-based predictor, i.e. from the partially reconstructed input signal.

The invention will be readily understood from the following description taken in conjunction with the accompanying drawings, in which:—

Figure 1 is a schematic representation of an ADPCM system according to the prior art;

Figure 2 is a schematic representation of a first exemplary embodiment of the invention;

Figure 3 is a schematic representation of a second exemplary embodiment of the invention; and

Figure 4 is a schematic representation of a third exemplary embodiment of the invention.

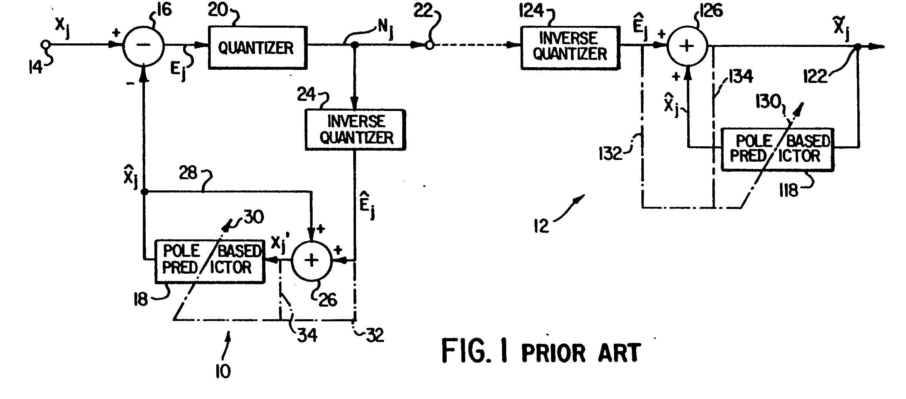

Referring to Figure 1, a conventional adaptive differential pulse code modulation system (ADPCM) with adaptive prediction comprises a transmitter 10 and a receiver 12. A digital signal to be transmitted is applied to an input terminal 14 of the transmitter 10. The signal is represented as $X_j$, signifying it is applied at time point or sample period j. The input terminal 14 is connected to a subtractor 16, which provides a difference signal $E_j$ obtained by subtracting from the input signal $X_j$ a predicted signal $\hat{X}_j$, being the output $\hat{X}_{jp}$ of a pole-based predictor 18. The difference signal $E_j$ is quantized by a quantizer 20 to provide a corresponding numeric representation $N_j$ at transmitter output terminal 22 for transmission to the receiver 12.

Generally the quantizer 20 will be adaptive i.e. its step size or transfer function will vary according to the input signal magnitude. Such quantizers are known and so will not be described in detail here. It should be noted that although an adaptive quantizer is preferred, a fixed quantizer might be used instead.

The numerical representation $N_j$ is also applied to an inverse quantizer 24 which regenerates the difference signal $\hat{E}_j$. Naturally, the characteristics of the inverse quantizer 24 must match those of the quantizer 20, and so will be adaptive if quantizer 20 is adaptive.

An adder 26 sums the regenerated difference signal $E_j$ with the predictor output signal $\hat{X}_{jp}$, constituting the predicted value $\hat{X}_j$, to provide a reconstructed input signal $X'_j$ at the input of predictor 18. The pole-based predictor 18 has a feedback loop 28 which applies the predictor output $\hat{X}_{jp}$ to the adder 26. The predictor 18 derives the signal $\hat{X}_{jp}$ using the past input signal values in accordance with the equations:—

$$\hat{X}_{jp}=A_1 X'_{j-1}+A_2 X'_{j-2}\ldots+A_n X'_{j-n} \qquad\qquad 3$$

where $A_1$—$A_n$ are prediction coefficients.

The predictor coefficients are adaptively corrected, as signified by arrow 30, in dependence upon the regenerated difference sinal $\hat{E}_j$, as signified by the broken line 32, and upon the previously reconstructed input signal $X'_j$, as signified by the broken line 34. More specifically, the coefficients $A_i^j$ are adaptively corrected in accordance with the equation:—

$$A_i^{j+1}=A_i^j(1-\delta_i)+g\cdot F_1(X'_{j-i})F_2(\hat{E}_j) \qquad\qquad 3a$$

where g is a positive small value and $F_1$ and $F_2$ are non-decreasing functions.

The receiver 12 comprises an inverse quantizer 124, and a pole-based predictor 118, corresponding to inverse quantizer 24 and predictor 18 in the transmitter 10. The receiver inverse quantizer 124 receives the numerical representation $N_j$ from the transmitter 10 and produces therefrom the regenerated difference signal $\hat{E}_j$. An adder 126 sums the predicted signal $\hat{X}_j$, constituted by the output signal $\hat{X}_{jp}$ from the predictor 118, with the difference signal $\hat{E}_j$ to produce the reconstructed input signal $\tilde{X}_j$ at the output terminal 122 of the receiver 12. This signal $\tilde{X}_j$ is also applied to the input predictor 118.

The coefficients of receiver predictor 118 are adaptively corrected in like manner to those of the transmitter predictor 18 as indicated by corresponding broken lines 132 and 134.

The receiver 12 operates in the inverse manner to the transmitter 10 and will faithfully reconstruct the original signal so long as the predictor coefficients are the same in both predictors 18 and 118 at any instant in time. The receiver and transmitter are then said to be "tracking". As mentioned previously, however, in practice errors will occur in the transmission between the transmitter and the receiver. These errors will result in differences between the prediction coefficients of the predictors 18 and 118 so the receiver output will no longer faithfully reproduce the original signal. In most cases, once the errors have ceased, the coefficients in the receiver will realign with those in the transmitter. The mechanisms whereby this is achieved are stability checks which restrict the range of the predictor and the leakage factor $(1-\delta)$ so that they will converge. There is a limit to the extent to which these mechanisms can be applied whilst assuring adequate predictor performance.

It has been found that "mistracking" can occur, however, when the input signal comprises two tones of different frequency. "Mistracking" is a situation arising when the transmission errors have ceased and the prediction coefficients in the transmitter and receiver have stabilized, but are not the same. The effect then is to amplify one tone and attenuate the other.

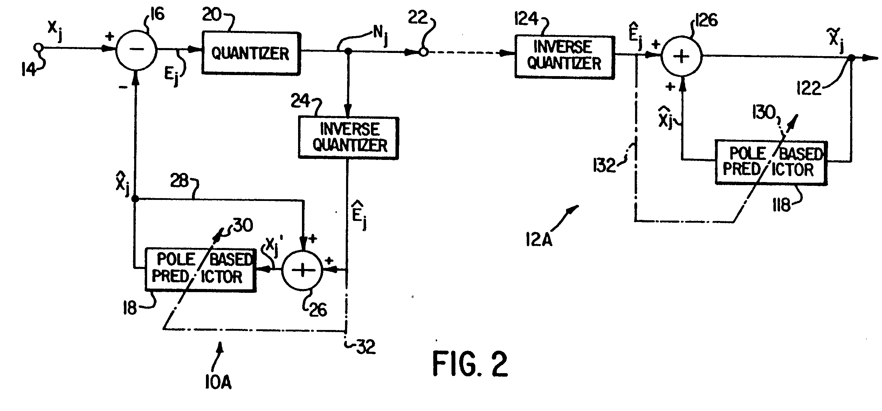

In embodiments of the present invention the problem is overcome by not using the reconstructed input signal $X'_j$, $\tilde{X}_j$ to adjust the predictor coefficients. Thus, referring to Figure 2, which illustrates a first embodiment of the invention, the component parts of the transmitter 10A and receiver 12A are the same as those illustrated in Figure 1 and so for ease of description corresponding parts are identified by the same reference numeral. It should be noted, however, that in Figure 2 there are no broken lines corresponding to lines 34 and 134 in Figure 1. This is because the prediction coefficients are no longer dependent upon $X'_j$, $\tilde{X}_j$, the reconstructed input signal.

4

In the embodiment shown in Figure 2, the predictor coefficients are derived in accordance with the general equation:—

$$A_i^{j+1} = A_i^j(1-\delta_i) + g \cdot F_i(\hat{E}_j, \hat{E}_{j-1}, \ldots \hat{E}_{j-n}, A_1^j \ldots A_{i-1}^j) \qquad 4$$

where i is the number of the coefficient from 1 to n, the higher numbers corresponding to earlier time values.

$\delta_i$ is a positive constant much smaller than one;

g is a proper positive constant;

$\hat{E}_j$ is the value of the difference signal at time point j;

$A_i$ is the respective predictor coefficient at time point j; and

$F_i$ is a non-linear function.

It should be noted that when i=1, the function $F_i$ will not have any arguments $A_1$—$A_{i-1}$.

This approach to adapting the predictor coefficients avoids any dependence upon the output at the predictor $\hat{X}_{jp}$ in the receiver so that mistracking due to dual tones is avoided. The main features guaranteeing tracking are:—

(A) $F_i$ depends on a finite number n of past values of the difference signal $\hat{E}_j$; and

(b) $F_i$ depends on $A_k^j$ only up to k=i−1 (Thus $A_i^j$ does not depend on any $A_k$).

In these equations for coefficients $A_i$, the first term is a linear decay term to allow effects of transmission errors to die away, and the second term is the adaptation term. Whilst a system for transmitting signals, such as speech, over telecommunications networks will usually require the first term, it should be appreciated that the $\delta_i$ constant might be omitted in some ADPCM system applications.

Although the system illustrated in Figure 2 can be used wiht only one pole, or several poles, it is preferred to use two poles in the predictors 18 and 118.

In such a case, the predictor coefficients $A_1$ and $A_2$ are derived according to the equations:—

$$A_1^{j+1} = A_1^j(1-\delta_1) + g_1 \cdot \hat{E}_j \cdot \hat{E}_{j-1}/K_j \qquad 5$$

$$A_2^{j+1} = A_j^2(1-\delta_2) + g_2 \cdot [\hat{E}_j \cdot \hat{E}_{j-2} - A_1^j \cdot \hat{E}_j \cdot \hat{E}_{j-1}]/K_j \qquad 6$$

where $K_j = \text{Max} (d, \hat{E}_j^2, \hat{E}_{j-1}^2, \hat{E}_{j-2}^2)$;

$\delta_1$ and $\delta_2$ are positive values much smaller than 1 (for example 1/256 and 1/128, respectively); and $g_1$ and $g_2$ and d are proper positive constants, e.g. 1/32, 1/32 and $10^{-6}$, respectively.

The values for $g_1$ and $g_2$ are chosen depending upon the characteristics of the signal and those specified are typically suitable for speech. Other values may be used providing the ratios of $\delta_1:g_1$ and $\delta_2:g_2$ are maintained about 1:8 and 1:4, respectively.

A particularly economic implementation of the invention can be achieved by approximating the coefficient equations as follows:—

$$A_1^{j+1} = A_1^j(1-\delta_1) + g_1 \text{sgn}(\hat{E}_j)\text{sgn}(\hat{E}_{j-1}) \qquad 7$$

$$A_2^{j+1} = A_2^j(1-\delta_2) + g_2[\text{sgn}(\hat{E}_j)\text{sgn}(\hat{E}_{j-2}) - f(A_1^j)\text{sgn}(\hat{E}_j)\text{sgn}(\hat{E}_{j-1})] \qquad 8$$

$$\text{where } f(A_1^j) = 2\text{sgn}(A_1^j) \text{ if } |A_1^j| > \tfrac{1}{2} \qquad 9$$

=$4A_1^j$ otherwise and $\delta_1$ and $\delta_2$ are about 1/181 and 1/90, respectively, and $g_1$ and $g_2$ are 1/64 and 1/90, respectively.

The values of $g_1$ and $g_2$ are typically suitable for speech signals. Other values may be used depending upon the characteristics of the signal, providing the ratios of $\delta_1:g_1$ and $\delta_2:g_2$ are maintained at about $1:2\sqrt{2}$ and unity, respectively.

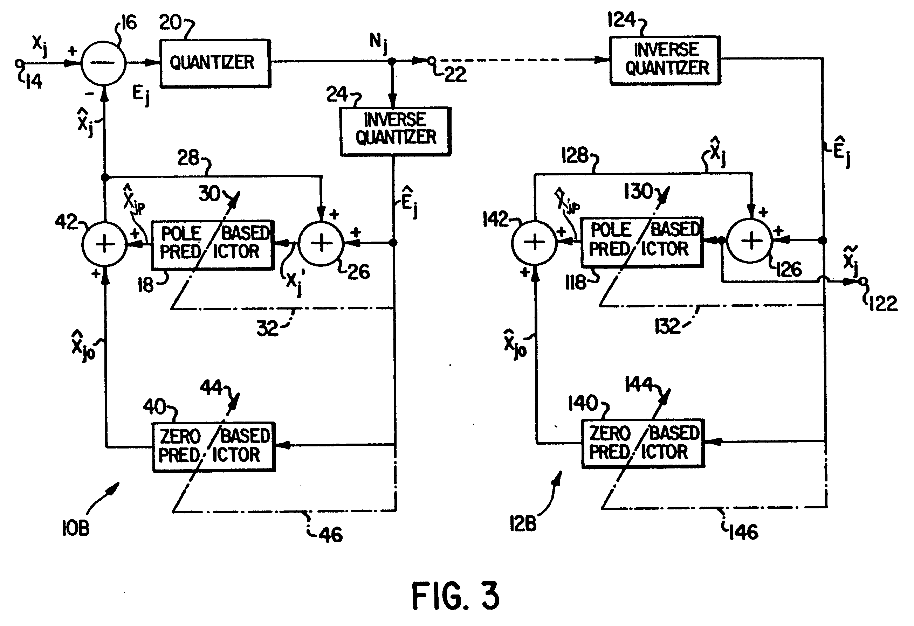

In many applications satisfactory results will be obtained using the embodiment shown in Figure 2. However, in some cases, to maximize the signal to noise ratio for certain input signals, an additional predictor, not using feedback, may be added. Such an embodiment is illustrated in Figure 3, in which parts corresponding to those shown in Figure 2, have the same reference numeral.

The transmitter 10B differs from that in Figure 2 by the addition of a zero-based predictor 40 (having no feedback) which produces from the regenerated difference signal $E_j$ a partial predicted value $\hat{X}_{jo}$. A second adder 42 sums the outputs $\hat{X}_{jo}$, $\hat{X}_{jp}$ of the zero-based predictor 40 and the pole-based predictor 18 to produce the predicted value $\hat{X}_j$. It should be noted that the coefficients of predictor 40, adaptive as signified by arrow 44, are adaptive only in dependence upon difference signal $\hat{E}_j$ as signified by broken line 46 and it has no feedback loop. A corresponding predictor 140 and adder 142 are provided in the receiver 12B.

It is envisaged that where predictor 18 has two coefficients, the zero-based predictor 40 might have six coefficients. The zero-based predictor coefficients may be derived in accordance with the teachings of U.S. Patent No. 4,317,208.

Where additional predictor 40 is provided, the coefficients of the pole-based predictor 18 may be adapted in dependence upon the output of the additional predictor 40, as well as the difference signal $\hat{E}_j$.

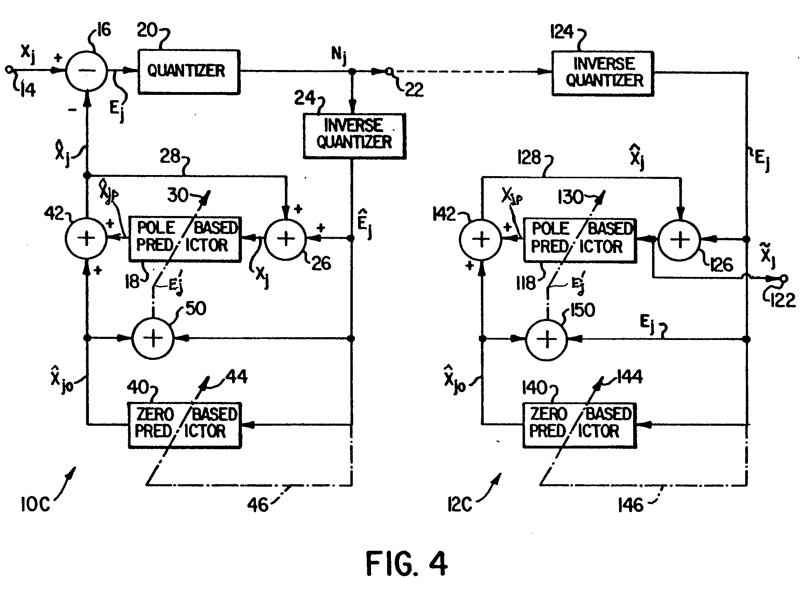

Such an arrangement is illustrated in Figure 4, in which the transmitter 10C differs from Figure 3 by the

inclusion of a third adder 50 which sums the difference signal $\hat{E}_j$ and the partial predicted value $\hat{X}_{jo}$ at the output of the zero-based predictor 40 to provide an adaptation signal $E'_j$ which controls adaptation of the coefficients of the pole-based predictor 18. The receiver 12C has a corresponding third adder 150 connected to like manner.

In both the transmitter and receiver, the equations for deriving the coefficients will be the same as for other embodiments, except that the term $\hat{E}_j$ is replaced by $E'_j$, defined as the sum of the difference signal $\hat{E}_j$ and the partial predicted value $\hat{X}_{jo}$.

**Claims**

1. A transmitter for transmitting an adaptive differential pulse code modulated signal, including; a subtractor (16) for deriving the difference $E_j$ between an input signal $X_j$ and a predicted value $\hat{X}_j$, a quantizer (20) for quantizing the difference signal $\hat{E}_j$ from said subtractor to obtain a numeric representation $N_j$ thereof;

an inverse quantizer (24) for recovering the difference signal $\hat{E}_j$ from said numeric representation $N_j$,

summing means (26) for summing the difference signal $\hat{E}_j$ and the predicted value $\hat{X}_j$ to provide a reconstructed signal $X'_j$;

predictor means (18) having variable prediction coefficients for receiving the reconstructed signal $X'_j$ from said memory means and generating therefrom an output signal $\hat{X}_{jp}$ constituting at least part of said predicted value $\hat{X}_j$; and

a feedback loop (28) for applying said predicted values $\hat{X}_j$ to said summing means;

characterized in that said predictor means (18) is adapted to derive each predictor coefficient as a non-linear function dependent upon a finite number of past values of the difference signal on residual $(\hat{E}_j)$ and not directly dependent on the reconstructed signal $X'_j$.

2. A transmitter as defined in claim 1, wherein said predictor means (18) is adapted to derive the predictor output signal $\hat{X}_{jp}$ in accordance withi the equation:

$$\hat{X}_{jp}=A_1X'_{j-1}+A_2X'_{j-2} \ldots +A_nX'_{j-n} \qquad\qquad 3$$

wherein $A_i$—$A_n$ are the predictor coefficient values defined by:—

$$A_i^{j+1}=A_i^j(1-\delta_i)+g \cdot F_i(\hat{E}_j,\hat{E}_{j-1}, \ldots \hat{E}_{j-n},A_i^j \ldots A_{i-1}^j) \qquad\qquad 4$$

wherein $i=1 \ldots n$, the number of pole-predictor coefficients;

$\delta_i$ is a positive constant much smaller than one;

$g$ is a proper positive constant;

$\hat{E}_j$ is the value of the quantized difference signal at time point j,

$A_i^j$ is the respective predictor coefficient at time point j, and

$X'_j$ is the sum of the difference signal $\hat{E}_j$ and the predicted value $\hat{X}_j$.

3. A transmitter as defined in claim 2, wherein the predictor means (18) is adapted to derive a plurality of coefficients, corresponding to past values occurring at different times, and to use a non-linear function, for other than the lowest coefficient derived also from the immediate past coefficient values of one or more lower-numbered predictor coefficients.

4. A transmitter as defined in claim 3, wherein said predictor means (18) is adapted to derive two predictor coefficients $A_1$ and $A_2$ in accordance with the equations:—

$$A_1^{j+1}=A_1^j(1-\delta_1)+g_1 \cdot \hat{E}_j \cdot \hat{E}_{j-1}/K_j \qquad\qquad 5$$

$$A_2^{j+1}=A_2^j(1-\delta_2)+g_2 \cdot [\hat{E}_j \cdot \hat{E}_{j-2}-A_1^j \cdot \hat{E}_j \cdot \hat{E}_{j-1}]/K_j \qquad\qquad 6$$

$K_j=Max(d, \hat{E}_j^2, \hat{E}_{j-1}^2, \hat{E}_{j-2}^2)$ where j is a particular sample period;

$\delta_1$ and $\delta_2$ are positive values much smaller than 1;

$g_1$ and $g_2$ and d are proper positive constants.

5. A transmitter as defined in claim 1, 2, 3 or 4 wherein said predictor means (18) provides a part only of the predicted value $\hat{X}_j$ and said transmitter further comprises:—

second prediction means (40) having variable coefficients and no feedback loop for providing from the regenerated difference signal $\hat{E}_j$ a partial predicted value $\hat{X}_{jo}$, and

a second summing means (42) for summing the output $\hat{X}_{jp}$ of the first mentioned predictor means and the partial predicted value $\hat{X}_{jo}$ to provide said predicted value $\hat{X}_j$.

6. A transmitter as defined in claim 5, further comprising:—

a third summing means (50) for summing the partial predicted value $\hat{X}_{jo}$ and the regenerated difference signal $\hat{E}_j$ to provide an adaptation signal $E'_j$;

said first predictor means (18) prediction coefficients being derived in dependence upon said adaptation signal.

7. A transmitter as defined in claim 2, 5 or 6, wherein said first predictor means (18) is adapted to derive two predictor coefficients $A_1$ and $A_2$ in accordance with the equations:

$$A_1^{j+1}=A_1^j(1-\delta_1)+g_1 sgn(\hat{E}_j)sgn(\hat{E}_{j-1}) \qquad 7$$

$$A_2^{j+1}=A_2^j(1-\delta_2)+g_2[sgn(\hat{E}_j)sgn(\hat{E}_{j-2})-f(A_1^j)sgn(\hat{E}_j)sgn(\hat{E}_{j-1})] \qquad 8$$

where

$$f(A_1^j)=2sgn(A_1^j) \ \text{if} \ |A_1^j|>\tfrac{1}{2} \qquad 9$$

$=4A_1^j$ otherwise.

8. A transmitter as defined in claim 7, wherein the constants $\delta_1$, $\delta_2$, $g_1$ and $g_2$ are determined such that the ratios $\delta_1:g_1$ and $\delta_2:g_2$ are about $1:2\sqrt{2}$ and unity, respectively.

9. A transmitter as defined in claim 8, wherein the constants $\delta_1$, $\delta_2$, $g_1$ and $g_2$ are about 1/181, 1/90, 1/64 and 1/90, respectively.

10. A transmitter as defined in claim 4 or 6, wherein the constants $\delta_1$, $\delta_2$, $g_1$ and $g_2$ are determined such that the ratios $\delta_1:g_1$ and $\delta_2:g_2$ are about 1:8 and 1:4, respectively.

11. A transmitter as defined in claim 10, wherein the constants $g_1$ and $g_2$ are substantially equal.

12. A transmitter as defined in claim 11, wherein the constants $\delta_1$, $\delta_2$, $g_1$ and $g_2$ are substantially equal to 1/256, 1/128, 1/32 and 1/32, respectively.

13. A receiver for receiving an adaptive differential pulse code modulated signal, comprising an inverse quantizer (124) for recovering a receiver quantized difference signal $\hat{E}_j$ from a received numeric representation, $N_j$;

summing means (126) for combining a predicted value $\hat{X}_j$ and a receiver quantized difference signal $\hat{E}_j$ to provide a reconstructed signal $\tilde{X}_j$;

predictor means (118) having variable prediction coefficients, for receiving said reconstructed signal and providing therefrom a predictor output $\hat{X}_{jp}$ constituting at least part of said predicted value $\hat{X}_j$;

characterised in that said predictor means (118) is adapted to derive each predictor coefficient as a non-linear function dependent upon a finite number of past values of the difference signal or residual $\hat{E}_j$ and not directly dependent on the reconstructed signal $\tilde{X}_j$.

14. A receiver as defined in claim 13, wherein said predictor means (118) is adapted to derive the predictor output signal $\hat{X}_{jp}$ in accordance with the equation:—

$$\hat{X}_{jp}=A_1\tilde{X}_{j-1}+A_2\tilde{X}_{j-2}\ldots+A_n\tilde{X}_{j-n} \qquad 3$$

wherein $A_i$—$A_n$ are the predictor coefficient values in said receiver defined by:—

$$A_i^{j+1}=A_i^j(1-\delta_i)+g\cdot F_i(\hat{E}_j,\hat{E}_{j-1},\ldots\hat{E}_{j-n},A_1^j\ldots A_{i-1}^j) \qquad 4$$

wherein $i=1\ldots n$, the number of pole-predictor coefficients;

$\delta_i$ is a positive constant much smaller than one;

g is a proper positive constant;

$\hat{E}_j$ is the value of the quantized difference signal at time point j;

$A_i^j$ is the respective predictor coefficient at time point j; and

$\tilde{X}_j$ is the sum of the difference signal $\hat{E}_j$ and the predicted value $\hat{X}_j$.

15. A receiver as defined in claim 14, wherein the predictor means (118) is adapted to derive a plurality of coefficients, corresponding to past values occurring at different times, and to use a non-linear function, for other than the lowest coefficient, derived also from the immediate past coefficient values of one or more lower numbered predictor coefficients.

16. A receiver as defined in claim 15, wherein said predictor means (118) is adapted to derive two predictor coefficients $A_1$ and $A_2$ in accordance with the equations:—

$$A_1^{j+1}=A_1^j(1-\delta_1)+g_1\cdot\hat{E}_j\cdot\hat{E}_{j-1}/K_j \qquad 5$$

$$A_2^{j+1}=A_2^j(1-\delta_2)+g_2\cdot[\hat{E}_j\cdot\hat{E}_{j-2}-A_1^j\cdot\hat{E}_j\cdot\hat{E}_{j-1}]/K_j \qquad 6$$

$K_j=\text{Max} \ (d, \hat{E}_j^2, \hat{E}_{j-1}^2, \hat{E}_{j-2}^2)$ where j is a particular sample period;

$\delta_1$ and $\delta_2$ are positive values much smaller than 1;

$g_1$ and $g_2$ and d are proper positive constants.

17. A receiver as defined in claim 13, 14, 15 or 16, wherein said first predictor means (118) provides a part only of the predicted value and said receiver further comprises:—

second predictor means (140) having variable coefficients and no feedback loop for providing from the regenerated difference signal $\hat{E}_j$ a partial predicted value $\hat{X}_{jo}$ and

a second summing means (142) for summing the output $\hat{X}_{jp}$ of the first-mentioned predictor means and the partial predicted value $\hat{X}_{jo}$ to provide said predicted value $\hat{X}_j$.

## EP 0 131 817 B1

18. A receiver as defined in claim 17, further comprising:—

a third summing means (150) for summing the partial predicted value $\hat{X}_{jo}$ and the regenerated difference signal $\hat{E}_j$ to provide an adaptation signal $E'_j$;

said first predictor means (118) prediction coefficients being derived in dependence upon said adaptation signal.

19. A receiver as defined in claim 14, 17 or 18, wherein said first predictor means (118) is adapted to derive two predictor coefficients $A_1$ and $A_2$ in accordance with the equations:—

$$A_1^{j+1}=A_1^j(1-\delta_1)+g_1\operatorname{sgn}(\hat{E}_j)\operatorname{sgn}(\hat{E}_{j-1}) \qquad\qquad 7$$

$$A_2^{j+1}=A_2^j(1-\delta_2)+g_2[\operatorname{sgn}(\hat{E}_j)\operatorname{sgn}(\hat{E}_{j-2})-f(A_1^j)\operatorname{sgn}(\hat{E}_j)\operatorname{sgn}(\hat{E}_{j-1})] \qquad\qquad 8$$

where

$$f(A_1^j)=2\operatorname{sgn}(A_1^j) \quad\text{if } |\,A_1^j\,|>\tfrac{1}{2} \qquad\qquad 9$$

$=4\ A_1^j$ otherwise.

20. A receiver as defined in claim 19, wherein the constants $\delta_1$, $\delta_2$, $g_1$ and $g_2$ are determined such that the ratios $\delta_1{:}g_1$ and $\delta_2{:}g_2$ are about $1{:}2\sqrt{2}$ and unity, respectively.

21. A receiver as defined in claim 20, wherein the constants $\delta_1$, $\delta_2$, $g_1$ and $g_2$ are about 1/181, 1/90, 1/64 and 1/90, respectively.

22. A receiver as defined in claim 16 or 18, wherein the constants $\delta_1$, $\delta_2$, $g_1$ and $g_2$ are determined such that the ratios $\delta_1{:}g_1$ and $\delta_2{:}g_2$ are about 1:8 and 1:4, respectively.

23. A receiver as defined in claim 22, wherein the constants $g_1$ and $g_2$ are substantially equal.

24. A receiver as defined in claim 23, wherein the constants $\delta_1$, $\delta_2$, $g_1$ and $g_2$ are substantially equal to 1/256, 1/128, 1/32 and 1/32, respectively.

25. An adaptive differential PCM System with residual adaptation of feedback predictor comprising:

a transmitter (10) according to any one of claims 1 to 12 for transmitting an adaptively differential pulse code modulated signal; and

a receiver (12) according to the corresponding claim 13 to 24 respectively for receiving the adaptively differential pulse code modulated signal.

**Patentansprüche**

1. Sender zum Senden eines adaptiven differential-impulscode-modulierten Siganls mit:

einem Subtraktor (16) zum Ableiten der Differenz·$E_j$ zwischen einem Eingangssignal $X_j$ und einem prädizierten Wert $\hat{E}_j$, einem Quantisierer (20) zum Quantisieren des Differenzsignals $E_j$ vom Subtraktor, um eine numerische Darstellung $N_j$ desselben zu erhalten;

einem inversen Quantisierer (24) zum Wiedergewinnen des Differenzsiganles $\hat{E}_j$ aus der numerischen Darstellung $N_j$,

Summierungsmittel (26) zum Summieren des Differenzsiganls $\hat{E}_j$ und des prädizierten Wertes $\hat{X}_j$ zur Schaffung eines rekonstruierten Signales $X'_j$,

Prädiktormittel (18) mit variablen Prädiktionskoeffizienten zum Empfangen des rekonstruierten Signals $X'_j$ vom Summierungsmittel und Erzeugen eines Ausgangssignales $\hat{X}_{jp}$ daraus, das mindestens einen Teil des prädizierten Wertes $\hat{X}_j$ bildet; und

einer Rückkoppelschleife (28) zum Anlegen des prädizierten Wertes $\hat{X}_j$ an das Summierungsmittel;

dadurch gekennzeichnet, daß das Prädiktormittel (18) ausgelegt ist zum Ableiten jedes Prädiktorkoeffizienten als einer nichtlinearen Funktion, abhängig von einer begrenzten Anzahl vergangener Werte des Differenzsignales oder des Residuals ($\hat{E}_j$) und nicht direkt abhängig von dem rekonstruierten Signal $X'_j$.

2. Sender nach Anspruch 1, bei dem das Prädiktormittel (18) ausgelegt ist zum Ableiten des Prädiktorausgangssignals $\hat{X}_{jp}$ entsprechend der Gleichung:

$$\hat{X}_{jp}=A_1X'_{j-1}+A_2X'_{j-2}\ldots+A_nX'_{j-n} \qquad\qquad 3$$

wobei $A_1$—$A_n$ die Prädiktorkoeffizientenwerte sind, definiert durch:

$$A_i^{j+1}=A_i^j(1-\delta_i)+g\cdot F_i(\hat{E}_j,\hat{E}_{j-1},\ldots\hat{E}_{j-n},A_1^j\ldots A_{i-1}^j) \qquad\qquad 4$$

wobei i=1—n die Anzahl der auf Pol basierenden Prädiktorkoeffizienten,

$\delta_i$ eine positive Konstante viel kleiner als 1;

$g$ eine entsprechende positive Konstante;

$\hat{E}_j$ der Wert des quantisierten Differenzsignals zum Zeitpunkt j,

$A_i^j$ der jeweilige Prädiktorkoefffizient zum Zeitpunkt j, und

$X_j$ die Summe des Differenzsignals $\hat{E}_j$ mit dem prädizierten Wert $\hat{X}_j$ sind.

8

3. Sender nach Anspruch 2, bei dem das Prädiktormittel (18) ausgelegt ist, eine Vielzahl von Koeffizienten entsprechend vergangenen, zu verschiedenen Zeiten aufgetretenen Werten abzuleiten, und eine nichtlineare Funktion zu verwenden für die anderen außer dem niedrigsten Koeffizienten, auch von den unmittelbar vorhergehenden Koeffizientenwerten eines oder mehrerer tiefer bezifferten Prädiktorkoeffizienten abgeleitet.

4. Sender nach Anspruch 3, bei dem das Prädiktormittel (18) ausgelegt ist, zwei Prädiktorkoeffizieten $A_1$ und $A_2$ entsprechend den Gleichungen abzuleiten:

$$A_1^{j+1}=A_1^j(1-\delta_1)+g_1 \cdot \hat{E}_j \cdot \hat{E}_{j-1}/K_j \qquad 5$$

$$A_2^{j+1}=A_2^j(1-\delta_2)+g_2 \cdot (\hat{E}_j \cdot \hat{E}_{j-2}-A_1^j \cdot \hat{E}_j \cdot \hat{E}_{j-1})/K_j \qquad 6$$

mit

$K_j=\text{Max } (d, \hat{E}_j^2, \hat{E}_{j-1}^2, \hat{E}_{j-2}^2)$,
wobei j eine bestimmte Abstastperiode bedeutet;
$\delta_1$ und $\delta_2$ positive Werte sehr viel kleiner als 1; und
$g_1$, $g_2$ und d entsprechende positive Konstanten sind.

5. Sender nach einem der Ansprüche 1, 2, 3 oder 4, bei dem das Prädiktormittel (18) nur einen Teil des prädizierten Wertes $\hat{X}_j$ schafft und der Sender weiter umfaßt:
zweite Prädiktionsmittel (40) mit variablen Koeffizienten und keiner Rückkoppelschleife, zur Schaffung eines partiellen prädizierten Wertes $\hat{X}_{jo}$ aus dem regenerierten Differenzsignal $\hat{E}_j$, und
ein zweites Summierungsmittel (42) zum Summieren des Ausgangssignales $\hat{X}_{jp}$ des ersterwähnten Prädiktormittels mit dem partiell prädizierten Wert $\hat{X}_{jo}$ zur Schaffung des prädizierten Wertes $\hat{X}_j$.

6. Sender nach Anspruch 5, weiter mit:
einem dritten Summierungsmittel (50) zum Summieren des partiell prädizierten Wertes $\hat{X}_{jo}$ mit dem regenerierten Differenzsignal $\hat{E}_j$ zur Schaffung eines Adaptionssignales $E'_j$;
wobei die Prädiktionskoeffizienten des ersten Prädiktormittels (18) in Abhängigkeit von dem Adaptionssignal abgeleitet werden.

7. Sender nach einem der Ansprüche 2, 5 oder 6, bei dem das erste Prädiktormittel (18) ausgelegt ist zum Ableiten von zwei Prädiktorkoeffizienten $A_1$ und $A_2$ entsprechend den Gleichungen:

$$A_1^{j+1}=A_1^j(1-\delta_1)+g_1\,\text{sgn}(\hat{E}_j)\text{sgn}(\hat{E}_{j-1}) \qquad 7$$

$$A_2^{j+1}=A_2^j(1-\delta_2)+g_2[\text{sgn}(\hat{E}_j)\text{sgn}(\hat{E}_{j-2})-f(A_1^j)\text{sgn}(\hat{E}_j)\text{sgn}(\hat{E}_{j-1})] \qquad 8$$

wobei

$$f(A_1^j)=2\text{sgn}(A_1^j), \quad \text{falls } |A_1^j|>\tfrac{1}{2} \qquad 9$$

sonst $=4A_1^j$.

8. Sender nach Anspruch 7, bei dem die Konstanten, $\delta_1$, $\delta_2$, $g_1$ und $g_2$ so bestimmt sind, daß die Verhältnisse $\delta_1:g_1$ und $\delta_2:g_2$ etwa $1:2\sqrt{2}$ bzw. 1 betragen.

9. Sender nach Anspruch 8, bei dem die Konstanten $\delta_1$, $\delta_2$, $g_1$ und $g_2$ etwa 1/181, 1/90, 1/64 bzw. 1/90 betragen.

10. Sender nach Anspruch 4 oder 6, bei dem die Konstanten $\delta_1$, $\delta_2$, $g_1$ und $g_2$ so bestimmt sind, daß die Verhältnisse $\delta_1:g_1$ und $\delta_2:g_2$ etwa 1:8 bzw. 1:4 betragen.

11. Sender nach Anspruch 10, bei dem die Konstanten $g_1$ und $g_2$ im wesentlichen einander gleich sind.

12. Sender nach Anspruch 11, bei dem die Konstanten $\delta_1$, $\delta_2$, $g_1$ und $g_2$ im wesentlichen gleich 1/256, 1/128, 1/32 bzw. 1/32 sind.

13. Empfänger zum Empfangen eines adaptiven differential-impulscodemodulierten Signales mit:
einem inversen Quantisierer (124) zum Wiedergewinnen eines im Empfänger quantisierten Differenzsignals $\hat{E}_j$ aus einer empfangenen numerischen Darstellung $N'_j$;
Summierungsmittel (126) zum Kombinieren eines prädizierten Wertes $\hat{X}_j$ und eines im Empfänger quantisierten Differenzsignals $\hat{E}_j$ zur Schaffung eines rekonstruierten Signales $\tilde{X}_j$;
Prädiktormittel (118) mit variablen Prädiktionskoeffizienten zum Empfangen des rekonstruierten Signals und Schaffen eines Prädiktorausgangssignales $\hat{X}_{jp}$ aus diesem, das mindestens einen Teil des prädizierten Wertes $\hat{X}_j$ bildet;
dadurch gekennzeichnet, daß
das Prädiktormittel (118) ausgelegt ist zum Ableiten jedes Prädiktorkoeffizienten als einer nichtlinearen Funktion in Abhängigkeit von einer begrenzten Anzahl von vergangenen Werten des Differenzsignales oder Residuals $\hat{E}_j$ und nicht direkt in Abhängigkeit von dem rekonstruierten Signal $\tilde{X}_j$.

14. Empfanger nach Anspruch 13, bei dem das Prädiktormittel (118) ausgelegt ist, das Prädiktorausgangssignal $\hat{X}_{jp}$ entsprechend der Gleichung abzuleiten:

$$\hat{X}_{jp}=A_1\tilde{X}_{j-1}+A_2\tilde{X}_{j-2} \ldots +A_n\tilde{X}_{j-n} \qquad 3$$

wobei $A_1$—$A_n$ die Prädiktorkoeffizientwerte in dem Empfänger sind, definiert durch:

$$A_i^{j+1}=A_i^j(1-\delta_1)+g \cdot F_i(\hat{E}_j,\hat{E}_{j-1},\ldots \hat{E}_{j-n},A_1^j \ldots A_{i-1}^j) \qquad \qquad 4$$

wobei $i=1$—$n$, die Anzahl der auf Pol basierenden Prädiktorkoeffizienten,

$\delta_i$ eine positive Konstante, viel kleiner als 1;

$g$ eine entsprechende positive Konstante;

$\hat{E}_j$ der Wert des quantisierten Differenzsignals zum Zeitpunkt j;

$A_i^j$ der jeweilige Prädiktorkoeffizient zum Zeitpunkt j, und

$\hat{X}_j$ die Summe des Differenzsignales $\hat{E}_j$ mit dem prädizierten Wert $\hat{X}_j$ sind.

15. Empfänger nach Anspruch 14, bei dem das Prädiktormittel (118) ausgelegt ist, eine Vielzahl von Koeffizienten abzuleiten, entsprechend den zu verschiedenen Zeiten aufgetretenen vergangenen Werten und eine nichtlineare Funktion für die anderen bis auf den niedrigsten Koeffizienten zu benutzen, ebenfalls aus dem unmittelbar vorhergehenden Koeffizientwerten von einem oder mehreren nieder bezifferten Prädiktorkoeffizienten abgeleitet.

16. Empfänger nach Anspruch 15, bei dem das Prädiktormittel (118) ausgelegt ist, zwei Prädiktorkoeffizienten $A_1$ und $A_2$ entsprechend den Gleichungen abzuleiten:

$$A_1^{j+1}=A_1^j(1-\delta_1)+g_1 \cdot \hat{E}_j \cdot \hat{E}_{j-1}/K_j \qquad \qquad 5$$

$$A_2^{j+1}=A_2^j(1-\delta_2)+g_2 \cdot (\hat{E}_j \cdot \hat{E}_{j-2}-A_1^j \cdot \hat{E}_j \cdot \hat{E}_{j-1})/K_j \qquad \qquad 6$$

mit $E_j=\text{Max} (d, \hat{E}_j^2, \hat{E}_{j-1}^2, \hat{E}_{j-2}^2)$, wobei j eine bestimmte Abtastperiode ist;

$\delta_1$ und $\delta_2$ positive Werte sehr viel kleiner als 1 und

$g_1, g_2$ und d entsprechende positive Konstanten sind.

17. Empfanger nach Anspruch 13, 14, 15 oder 16, bei dem das erste Prädiktormittel (118) nur einen Teil des prädizierten Wertes schafft und der Empfänger weiter umfaßt:

zweite Prädiktormittel (140) mit variablen Koeffizienten und keiner Rückkoppelschleife zur Schaffung eines partiell prädizierten Wertes $\hat{X}_{jo}$ aus dem regenerierten Differenzsignal $\hat{E}_j$ und

ein zweites Summiermittel (142) zum Summieren des Ausgangssignales $\hat{X}_{jp}$ des ersterwähnten Prädiktormittels mit dem partiell prädizierten Wert $\hat{X}_{jo}$ zur Schaffung des prädizierten Wertes $\hat{X}_j$.

18. Empfänger nach Anspruch 17, weiter mit: einem dritten Summiermittel (150) zum Summieren des prädizierten Partialwertes $\hat{X}_{jo}$ mit dem regenerierten Differenzsignal $\hat{E}_j$ zur Schaffung eines Adaptionssignales $E'_j$;

wobei die Prädiktionskoeffizienten des ersten Prädiktormittels (118) in Abhängigkeit von dem Adaptionssignal abgeleitet werden.

19. Empfänger nach Anspruch 14, 17 oder 18, bei dem das erste Prädiktormittel (118) ausgelegt ist zum Ableiten von zwei Prädiktorkoeffizienten $A_1$ und $A_2$ entsprechend den Gleichungen:

$$A_1^{j+1}=A_1^j(1-\delta_1)+g_1\text{sgn}(\hat{E}_j)\text{sgn}(\hat{E}_{j-1}) \qquad \qquad 7$$

$$A_2^{j+1}=A_2^j(1-\delta_2)+g_2[\text{sgn}(\hat{E}_j)\text{sgn}(\hat{E}_{j-2})-f(A_1^j)\text{sgn}(\hat{E}_j)\text{sgn}(\hat{E}_{j-1})] \qquad \qquad 8$$

wobei

$$f(A_1^j)=2\text{sgn}(A_1^j), \text{ falls } | A_1^j |>\tfrac{1}{2} \qquad \qquad 9$$

sonst$=4A_1^j$.

20. Empfänger nach Anspruch 19, bei dem die Konstanten $\delta_1, \delta_2, g_1$ und $g_2$ so bestimmt werden, daß die Verhältnisse $\delta_1{:}g_1$ und $\delta_2{:}g_2$ etwa $1{:}2\sqrt{2}$ bzw. 1 betragen.

21. Empfanger nach Anspruch 20, bei dem die Konstanten $\delta_1, \delta_2, g_1$ und $g_2$ etwa 1/181, 1/90, 1/64 bzw. 1/90 betragen.

22. Empfänger nach Anspruch 16 oder 18, bei dem die Konstanten $\delta_1, \delta_2, g_1, g_2$ so bestimmt sind, daß die Verhältnisse $\delta_1{:}g_1$ und $\delta_2{:}g_2$ etwa 1:8 bzw. 1:4 betragen.

23. Empfänger nach Anspruch 22, bei dem die Konstanten $g_1$ und $g_2$ im wesentlichen einander gleich sind.

24. Empfanger nach Anspruch 23, bei dem die Konstante $\delta_1, \delta_2, g_1$ und $g_2$ im wesentlichen gleich 1/256, 1/128, 1/32 bzw. 1/32 sind.

25. Adaptives Differential-PCM-System mit residualer Adaption von Rückkoppel-Prädiktoren mit:

einem Sender (10) nach einem der Ansprüche 1 bis 12 zum Senden eines adaptiv-differential-impulscodemodulierten Signales, und

einem Empfänger (12) nach dem entsprechenden aus den Ansprüchen 13 bis 24 zum Empfangen des adaptivdifferential-impulscodemodulierten Signales.

10

**Revendications**

1. Emetteur pour transmettre un signal à modulation par impulsions codées différentiel adaptatif, comprenant: un soustracteur (16) pour obtenir la différence $E_j$ entre un signal d'entrée $X_j$ et une valeur prédite $\hat{X}_j$, un quantificateur (20) pour quantifier le signal de différence $E_j$ provenant du soustracteur afin d'en donner une représentation numérique $N_j$;

un quantificateur inverse (24) pour récupérer le signal de différence $\hat{E}_j$ à partir de la représentation numérique $N_j$;

un moyen de sommation (26) pour additionner le signal de différence $\hat{E}_j$ et la valeur prédite $\hat{X}_j$ afin de fournir un signal construit $X'_j$;

un moyen de prediction (18) ayant des coefficients de prédiction variables pour recevoir le signal reconstruit $X'_j$ provenant du moyen de sommation et produire à partir de celui-ci un signal de sortie $\hat{X}_{jp}$ constituant au moins une partie de la valeur prédite $\hat{X}_j$; et

une boucle de réaction (28) pour appliquer la valeur prédite $\hat{X}_j$ au moyen de sommation;

caractérisé en ce que:

le moyen de prédiction (18) est destiné à donner chaque coefficient de prédiction sous forme d'une fonction non linéaire dépendant d'un nombre fini de valeurs passées du signal de différence ou résiduel ($\hat{E}_j$) et ne dépendant pas directement du signal reconstruit $X'_j$.

2. Emetteur selon la revendication 1, dans lequel le moyen de prédiction (18) est destiné à donner le signal $\hat{X}_{jp}$ de sortie du moyen de prédiction en conformité avec l'équation:

$$\hat{X}_{jp}=A_1 X'_{j-1}+A_2 X'_{j-2} \ldots +A_n X'_{j-n} \qquad 3$$

où $A_i \ldots A_n$ sont les valeurs des coefficients de prédiction définies par:

$$A_i^{j+1}=A_i^j(1-\delta_i)+g \cdot F_i(\hat{E}_j,\hat{E}_{j-1}, \ldots \hat{E}_{j-n},A_i^j \ldots A_{i-1}^j) \qquad 4$$

où $i=1. \cdot . n$, nombre de coefficients de prédiction-pôle;

$\delta_i$ est une constante positive très inférieure à un;

$g$ est une constante positive propre;

$\hat{E}_j$ est la valeur du signal de différence quantifié à l'instant j;

$A_i^j$ est le coefficient du moyen de prédiction respectif à l'instant j; et

$X'_j$ est la somme du signal de différence $\hat{E}_j$ et de la valeur prédite $\hat{X}_j$.

3. Emetteur selon la revendication 2, dans lequel le moyen de prédiction (18) est destiné à donner une multitude de coefficients, correspondant à des valeurs passées se produisent à des instants différents, et à utiliser une fonction non-linéaire, pour autre chose que le coefficient le plus faible obtenu également à partir des valeurs de coefficient de passé immédiat d'un ou de plusieurs coefficients de prédiction à numéro plus faible.

4. Emetteur selon la revendication 3, dans lequel le moyen de prédiction (18) est destiné à donner deux coefficents de prédiction $A_1$ et $A_2$ en conformité avec les équations:

$$A_1^{j+1}=A_1^j(1-\delta_1)+g_1 \cdot \hat{E}_j \cdot \hat{E}_{j-1}/K_j \qquad 5$$

$$A_2^{j+1}=A_2^j(1-\delta_2)+g_2 \cdot [\hat{E}_j \cdot \hat{E}_{j-2}-A_1^j \cdot \hat{E}_j \cdot \hat{E}_{j-1}]/K_j \qquad 6$$

$K_j=$ Max $(d, \hat{E}_j, \hat{E}_{j-1}, \hat{E}_{j-2})$ où j est une période particulière d'échantillonnage;

$\delta_1$ et $\delta_2$ sont des valeurs positives très inférieures à 1;

$g_1$ et $g_2$ et d sont des constantes positives propres.

5. Emetteur selon la revendication 1, 2, 3 ou 4, dans lequel le moyen de prédiction (18) fournit une partie seulement de la valeur prédite $\hat{X}_j$ et l'émetteur comprend en outre:

un second moyen de prédiction (40) ayant des coefficients variables et aucune boucle de réaction pour fournir à partir du signal de différence régénéré $\hat{E}_j$ une valeur prédite partielle $\hat{X}_{jo}$, et

un second moyen de sommation (42) pour additionner la sortie $\hat{X}_{jp}$ du moyen de prédiction cité en premier et la valeur prédite partielle $\hat{X}_{jo}$ pour fournir la valeur prédite $\hat{X}_j$.

6. Emetteur selon la revendication 5, comprenant en outre:

un troisième moyen de sommation (50) pour additionner la valeur prédite partielle $\hat{X}_{jo}$ et le signal de différence régénéré $\hat{E}_j$ pour fournir un signal d'adaptation $E'_j$;

les coefficients de prédiction du premier moyen de prédiction (18) étant obtenus en fonction du signal d'adaptation.

7. Emetteur selon la revendication 2, 5 ou 6, dans lequel le premier moyen de prédiction (18) est destiné à donner deux coefficients de prédiction $A_1$ et $A_2$ en conformité avec les équations:

$$A_1^{j+1}=A_1^j(1-\delta_1)+g_1 \text{sgn}(\hat{E}_j)\text{sgn}(\hat{E}_{j-1}) \qquad 7$$

$$A_2^{j+1}=A_2^j(1-\delta_2)+g_2[\text{sgn}(\hat{E}_j)\text{sgn}(\hat{E}_{j-2})-f(A_1^j)\text{sgn}(\hat{E}_j)\text{sgn}(\hat{E}_{j-1})] \qquad 8$$

où

$$f(A_1^j)=2\text{sgn}(A_1^j)\text{si}\mid A_1^j\mid>\tfrac{1}{2} \qquad 9$$

$=4A_1^j$ par ailleurs.

8. Emetteur selon la revendication 7, dans lequel les constantes $\delta_1$, $\delta_2$, $g_1$ et $g_2$ sont déterminées de façon que les rapporte $\delta_1:g_1$ et $\delta_2:g_2$ soient environ $1:2\sqrt{2}$ et l'unité, respectivement.

9. Emetteur selon la revendication 8, dans lequel les constantes $\delta_1$, $\delta_2$, $g_1$ et $g_2$ sont environ 1/181, 1/90, 1/64 et 1/90, respectivement.

10. Emetteur selon la revendication 4 ou la revendication 6, dans lequel les constantes $\delta_1$, $\delta_2$, $g_1$ et $g_2$ sont déterminées de façon telle que les rapports $\delta_1:g_1$ et $\delta_2:g_2$ soient environ 1:8 et 1:4, respectivement.

11. Emetteur selon la revendication 10, dans lequel les constantes $g_1$ et $g_2$ sont sensiblement égales.

12. Emetteur selon la revendication 11, dans lequel les constantes $\delta_1$, $\delta_2$, $g_1$ et $g_2$ sont sensiblement égales à 1/256, 1/128, 1/32 et 1/32, respectivement.

13. Récepteur pour recevoir un signal à modulation par impulsions codées différentiel adaptatif, comprenant un quantificateur inverse (124) pour récupérer un signal de différence quantifié $\hat{E}_j$ d'un récepteur à partir d'une représentation numérique reçue, $N_j$;

un moyen de sommation (126) pour combiner une valeur prédite $\hat{X}_j$ et un signal de différence quantifié $\hat{E}_j$ de récepteur pour fournir un signal reconstruit $\tilde{X}_j$;

un moyen de prédiction (118) ayant des coefficients de prédiction variables, pour recevoir le signal reconstruit et fournir à partir de lui une sortie de prédiction $\hat{X}_{jp}$ constituant au moins une partie de la valeur prédite $\hat{X}_j$;

caractérisé en ce que:

le moyen de prédiction (118) est destiné à donner chaque coefficient de prédiction sous forme d'une fonction non linéaire dépendant d'un nombre fini de valeurs passées du signal de différence ou résiduel $\hat{E}_j$ et ne dépendant pas directement du signal reconstruit $\tilde{X}_j$.

14. Récepteur selon la revendication 13, dans lequel le moyen de prédiction (118) est destiné à donner le signal $\hat{X}_{jp}$ de sortie du moyen de prédiction en conformité avec l'équation:

$$\hat{X}_{jp}=A_1\tilde{X}_{j-1}+A_2\tilde{X}_{j-2}\ldots+A_n\tilde{X}_{j-n} \qquad 3$$

où $A_1\ldots A_n$ sont les valeurs des coefficients de prédiction dans le récepteur définies par:

$$A_i^{j+1}=A_i^j(1-\delta_i)+g\cdot F_i(\hat{E}_j,\hat{E}_{j-1}\ldots\hat{E}_{j-n},A_1^j\ldots A_{i-1}^j) \qquad 4$$

où $i=1\ldots n$, nombre de coefficients de prédiction-pôle;

$\delta_i$ est une constante positive très inférieure à un;

$g$ est une constante positive propre;

$E_j$ est la valeur du signal de différence quantifié à l'instant j;

$A_i^j$ est le coefficient de prédiction respectif à l'instant j; et

$\tilde{X}_j$ est la somme du signal de différence $\hat{E}_j$ et de la valeur prédite $\hat{X}_j$.

15. Récepteur selon la revendication 14, dans lequel le moyen de prédiction (118) est destiné à donner une multitude de coefficients, correspondant à des valeurs passées se produisant à des instants différents, et à utiliser une fonction non linéaire, pour autre chose que le coefficient le plus bas, obtenu également à partir des valeurs des coefficients du passé immédiat d'un ou de plusieurs coefficients de prédiction de numéro inférieur.

16. Récepteur selon la revendication 15, dans lequel le moyen de prédiction (118) est destiné à donner deux coefficients de prédiction $A_1$ et $A_2$ en conformité avec les équations:

$$A_1^{j+1}=A_1^j(1-\delta_1)+g_1\cdot\hat{E}_j\cdot\hat{E}_{j-1}/K_j \qquad 5$$

$$A_2^{j+1}=A_2^j(1-\delta_2)+g_2\cdot[\hat{E}_j\cdot\hat{E}_{j-2}-A_1^j\cdot\hat{E}_j\cdot\hat{E}_{j-1}]/K_1 \qquad 6$$

$K_j=\text{Max }(d,\hat{E}_j^2,\hat{E}_{j-1}^2,\hat{E}_{j-2}^2)$ où j est une périobe particulère d'échantillonnage;

$\delta_1$ et $\delta_2$ sont des valeurs positives très inférieures à 1;

$g_1$ et $g_2$ et d sont des constantes positives propres.

17. Récepteur selon la revendication 13, 14, 15 ou 16, dans lequel le premier moyen de prédiction (118) fournit une partie seulement de la valeur prédite et le récepteur comprend en outre:

un second moyen de prédiction (140) ayant des coefficients variables et aucune boucle de réaction pour fournir à partir de signal de différence régénéré $\hat{E}_j$ une valeur prédite partielle $\hat{X}_{jo}$ et

un second moyen de sommation (142) pour additionner la sortie $\hat{X}_{jp}$ du moyen de prédiction cibé en premier et la valeur prédite partielle $\hat{X}_{jo}$ pour fournir ladite valeur prédite $\hat{X}_j$.

18. Récepteur selon la revendication 17, comprenant en outre:

un troisième moyen de sommation (150) pour additionner la valeur prédite partielle $\hat{X}_{jo}$ et le signal de différence régénéré $\hat{E}_j$ pour fournir un signal d'adaptation $E'_j$;

les coefficients de prédiction du premier moyen de prédiction (118) étant obtenus en fonction du signal d'adaptation.

19. Récepteur selon la revendication 14, 17 ou 18, dans lequel le premier moyen de prédiction (116) est destiné à donner deux coefficients de prédiction $A_1$ et $A_2$ en conformité avec les équation:

$$A_1^{j+1} = A_1^j(1-\delta_1) + g_1 \operatorname{sgn}(\hat{E}_j)\operatorname{sgn}(\hat{E}_{j-1}) \qquad\qquad 7$$

$$A_2^{j+1} = A_2^j(1-\delta_2) + g_2[\operatorname{sgn}(\hat{E}_j)\operatorname{sgn}(\hat{E}_{j-2}) - f(A_1^j)\operatorname{sgn}(\hat{E}_j)\operatorname{sgn}(\hat{E}_{j-1})] \qquad\qquad 8$$

où

$$f(A_1^j) = 2\operatorname{sgn}(A_1^j) \text{ si } |A_1^j| > \tfrac{1}{2} \qquad\qquad 9$$

$=4A_1$ per ailleurs.

20. Récepteur selon la revendication 19, dans lequel les constantes $\delta_1$, $\delta_2$, $g_1$ et $g_2$ sont déterminées de façon que les rapports $\delta_1{:}g_1$ et $\delta_2{:}g_2$ soient environ $1{:}2\sqrt{2}$ et l'unité respectivement.

21. Récepteur selon la revendication 20, dans lequel les constantes $\delta_1$, $\delta_2$, $g_1$ et $g_2$ sont environ 1/181, 1/90, 1/64 et 1/90, respectivement.

22. Récepteur selon la revendication 16 ou 18 dans lequel les constantes $\delta_1$, $\delta_2$, $g_1$ et $g_2$ sont déterminées de façon que les rapports $\delta_1{:}g_1$ et $\delta_2{:}g_2$ soient environ 1:8 et 1:4 respectivement.

23. Récepteur selon la revendication 22, dans lequel les constantes $g_1$ et $g_2$ sont sensiblement égales.

24. Récepteur selon la revendication 23, dans lequel les constantes $\delta_1$, $\delta_2$, $g_1$ et $g_2$ sont sensiblement égales à 1/256, 1/128, 1/32 et 1/32, respectivement.

25. Système MIC différential adaptatif avec adaptation résiduelle d'un moyen de prédiction à réaction, comprenant:

un émetteur (10) selon l'une quelconque des revendications 1 à 12 pour transmettre un signal à modulation per impulsions codées différentiel de façon adaptative; et

un récepteur (12) selon la revendication correspondante 13 à 24 respectivement pour recevoir le signal à modulation par impulsions codées différentiel de façon adaptative.

FIG. I PRIOR ART

FIG. 2

FIG. 3

FIG. 4